# EUROPEAN PATENT APPLICATION

(11) **EP 1 049 133 A2**
(43) Date of publication of application: **02.11.2000**
(21) Application number: 00109238.6
(22) Date of filing: 28.04.2000
(51) Int. Cl.: H01J 37/32

(54) **Enhancing adhesion of deposits on exposed surfaces in process chamber**

(30) Priority: 30.04.1999 US 303817
(71) Applicant: Applied Materials, Inc., Santa Clara, California 95052 (US)
(72) Inventor: Luscher, Paul, Sunnyvale, CA 94087 (US); Vaidya, Kaushik, Sunnyvale, CA 94086 (US); Salimian, Siamak, Sunnyvale, CA 94087 (US); Pu, Bryan Y., San Jose, CA 95135 (US); Lee, Evans Y., Milpitas, CA 95035 (US)
(74) Representative: Zimmermann, Gerd Heinrich

(57) **Abstract**

The invention provides an apparatus for fabricating semiconductor devices. The apparatus comprises a process chamber enclosing an interior region and a mechanical component having an exposed surface in the interior of the chamber, wherein, said surface includes a plurality of topographical features distributed across the surface. Each topographical feature has a height in the range of 0.1 to 100 mm and a width in the range of 0.1 to 100 mm and adjacent topographical features are separated by a spacing in the range of 0.1 to 100 mm.

## Description

The invention relates generally to process chambers for fabricating semiconductors. More specifically, the invention relates to chamber walls having a textured surface to promote adhesion of material which may be deposited on the walls during such semiconductor fabrication.

Many processes for fabricating semiconductor devices unavoidably deposit process byproduct material on the walls of the process chamber in which the processes are performed. For example, chemical processes for depositing a film on a semiconductor workpiece, and chemical processes for etching such films, typically create reaction products which deposit on the chamber walls. As another example, sputter deposition processes typically deposit a portion of the sputtered target material on the chamber walls. While the target material deposited on the walls of a sputtering chamber is the same as the material intended to be deposited on the workpiece, we consider this material to be a process byproduct to the extent it deposits on surfaces of chamber component instead of on the workpiece.

After the deposits accumulate to a certain thickness, the deposits will begin to flake off the chamber wall, thereby contaminating the semiconductor devices being fabricated. Therefore, the deposits must be removed from the chamber wall before they accumulate to the point where they may flake off.

One conventional method of removing the deposits is to periodically clean the inner surface of the chamber wall by either plasma etching or by manually applying a liquid solvent. Another conventional method is to cover the chamber walls with a removable liner, and to periodically replace the liner when the accumulation of deposits becomes excessive.

Shutting down an expensive process chamber for periodic cleaning or maintenance is very costly in terms of lost semiconductor production. Therefore, there is a need for improved process chambers which reduce the required frequency of cleaning or replacing chamber walls or liners.

One conventional method for reducing the required frequency of chamber cleaning is to improve the deposited material's adhesion to the chamber wall or lining by roughening the inner surfaces of such wall or lining by bead blasting. While this method does reduce the required frequency of chamber cleaning, the reduction is modest, and further improvement would be desirable.

The present invention intends to overcome the above problems. The object is solved by the apparatuses for processing semiconductor devices according to independent claims 1 and 10 and by the methods according to independent claims 12 and 14.

Further advantages, features, aspects and details of the invention are evident from the dependent claims, the description and the accompanying drawings.

The present invention generally relates to an apparatus for processing semiconductors. In particular, it relates to etching process chambers and to deposit chambers.

Therefore, it is the object of the invention to provide a method and apparatus for processing semiconductor workpieces, or a component adapted for use in such apparatus, wherein a component surface is textured so that process byproduct material deposited on the textured surface will have improved adhesion. The dimensions of the texturing according to our invention are much greater than the dimensions of the texturing conventionally produced by conventional bead blasting. The improved adhesion enables a thicker layer of material to be deposited on the textured surface without risk of the material flaking off. Consequently, the invention enables the chamber to operate a longer period of time before it must be shut down to clean or replace the chamber wall or lining.

The invention will be better understood by reference to the following description of embodiments of the invention taken in conjunction with the accompanying drawings wherein
Figure 1 is a partially schematic, plan view of a conventional plasma etching chamber in which the invention can be implemented.
Figures 2 and 3 are top and sectional views, respectively, of a plate in which has been formed a texture consisting of square protrusions.
Figure 4 is a sectional view of an alternative to the embodiment of Figure 3 in which the sides of the square depressions are formed at an oblique angle.
Figures 5 and 6 are top and sectional views, respectively, of an alternative embodiment in which the depressions are hemispherical in shape.
Figures 7 and 8 are perspective and sectional views, respectively, of a texture consisting of a series of circumferential grooves in a cylindrical side wall liner.
Figure 9 is a perspective view of a cylindrical liner having both circumferential and longitudinal grooves.

### Overview of Conventional Process Chamber

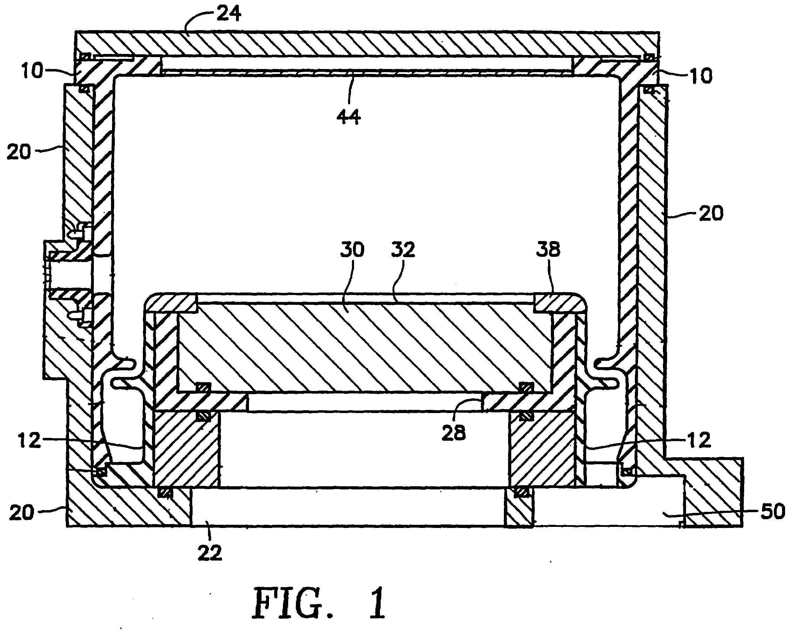

The invention can be applied to any process chamber used for performing semiconductor fabrication processes which deposit material on the chamber walls and other exposed surfaces within the chamber. As an example of such a process chamber, Figure 1 shows a vacuum chamber used for plasma etching of silicon oxide dielectric layers on a 200 mm diameter silicon wafer.

The interior of the vacuum chamber is enclosed by a cylindrical side wall 20, an annular bottom wall 22, and a circular top wall 24, all of which are composed of anodized aluminum.

A disc-shaped aluminum cathode electrode 30 has a flat, circular top surface 32 on which a silicon wafer to be etched is placed by a robot (not shown). The cathode 30 rests atop a dielectric spacer 28 that electrically insulates the cathode from the chamber bottom wall 22.

The ungrounded output terminal of an RF power supply (not shown) connects to the cathode 30, and the other power supply output terminal connects to the electrically grounded chamber wall 20, 22, 24. A quartz dielectric ring 38 rests atop the cathode and protects the top perimeter of the cathode from exposure to the plasma. The remaining top surface 32 of the cathode is covered by a semiconductor wafer during chamber operation.

A perforated, circular, gas distribution plate 44, commonly called a showerhead, is mounted on the underside of the chamber top wall 24. A gap between the gas distribution plate and the top wall functions as a gas inlet manifold. One or more gas supply lines, not shown, convey process gases to the inlet manifold area above the gas distribution plate. The process gases then flow through the perforations or apertures in the gas distribution plate and into the interior of the chamber. In the silicon oxide etch chamber used as an example, the gas distribution plate has a diameter of about 220 mm and has about ninety gas distribution apertures of diameter 0.6 mm spaced about 20 mm apart.

The gas distribution plate can be composed of anodized aluminum. However, because it is difficult to prevent defects in the anodization at the edges of the gas distribution apertures, the gas distribution plate more preferably is composed of quartz, aluminum oxide (alumina), aluminum nitride, or silicon carbide.

The top wall 24 and the gas distribution 44 in combination are referred to as the chamber lid because they are designed to be easily removed from the chamber as a single unit to permit maintenance of the chamber interior. Because the gas distribution plate constitutes the upper boundary of the chamber interior, it also is referred to as the roof of the chamber.

The process gases exit the chamber in the chamber bottom wall 22. A vacuum pump (not shown) pumps process gases out of the chamber through a circular exhaust port 50 and maintains a desired level of vacuum within the chamber.

To facilitate chamber cleaning, the chamber side wall 20 is covered by a removable anode liner 10, and the cathode 30 and cathode spacer 25 are covered by a removable cathode liner 12. Each of the two liners 10 and 12 is cylindrically symmetrical and coaxial with the chamber side wall 20 and the cathode 30. The two removable liners 10,12 typically are composed of anodized aluminum or ceramic.

### Chamber Operation and Deposition on Chamber Surfaces

In operation, the RF electrical power applied between the cathode electrode 30 and the grounded chamber wall 20, 22, 24 excites die process gases into a plasma state. A significant proportion of the gas molecules in die plasma are dissociated into their constituent atoms, ions, and free electrons. These particles interact with each other and with the surface material of the semiconductor workpiece to perform a desired semiconductor device fabrication process, such as depositing a film onto the workpiece, or etching a layer from the surface of the workpiece.

Many semiconductor fabrication processes undesirably deposit material on exposed surfaces within the chamber. In the illustrated embodiment, such deposition would occur on the exposed surfaces of the two liners 10, 12 and the gas distribution plate 44. For example, in a conventional plasma-assisted etching process using fluorocarbon etching gases, polymers typically would be deposited on the exposed surfaces. After the deposits accumulate to a certain thickness, the deposits will begin to flake off the lid and the chamber liners, thereby contaminating the semiconductor devices being fabricated. Therefore, the material deposited on the lid and chamber liners must be cleaned off before the deposits accumulate to the point where they may flake off.

For example, in our conventional process for etching silicon oxide, using an etchant gas mixture containing C₄F₈ and CO, a fluorocarbon polymer deposits on the gas distribution plate and the chamber liners. We find that this polymer adheres to the plate and liners only up to a thickness of 0.6 to 0.65 mm. Above that thickness, the deposited material begins to flake off of the plate and liners, thereby contaminating the wafer. Therefore, we must estimate the number of hours that the etching process can be performed, or the number of wafers that can be processed, before the polymer deposits reach this critical thickness on any portion of the lid or liner. After that number of hours or wafers, the lid and chamber liners must be cleaned.

Removing the accumulated deposits from the lid and chamber liners requires shutting down the process chamber, removing the lid and chamber liners, and soaking or rubbing them with a solvent or etching solution. After they are cleaned, the lid and liners can be replaced in the chamber.

As previously stated in the Background of the Invention, shutting down an expensive process chamber for periodic cleaning or replacement of the lid and liners is very costly in terms of lost semiconductor production. Therefore, there is a need for improved process chambers which reduce the required frequency of cleaning or replacing chamber walls or liners, i.e., which allow the chamber to be operated for a much greater number of hours before it must be shut down to clean the chamber walls or to clean or replace the liners.

### Novel Textured Surface on Chamber Components

Our invention improves adhesion of reaction products or other material deposited on surfaces within the process chamber that are exposed to process gases, thereby allowing the chamber to be operated for longer time intervals between cleaning such surfaces. Specifically, in our invention such surfaces are fabricated with a surface contour or "texture" having topographical features ― i.e., alternating protrusions and depressions (peaks and troughs) ― whose width, spacing, and height dimensions are between 100 microns (0.1 mm) and 100 mm, and preferably in the range of 500 microns (0.5 mm) to 8000 microns (8 mm). In contrast; the average roughness of surfaces treated by conventional bead blasting is about 4 to 6 microns (0.15 to 0.23 mil), which is at least 16 times smaller than the features of the invention.

By "topographical feature" or "elevation feature" of the surface we mean an area whose elevation deviates from the average surface elevation. A topographical feature can be either a convex protrusion or a concave depression. The "height" of a feature is the peak-to-trough deviation in elevation. If the feature is a concave depression, the "height" of the feature is the depth of the depression.

We believe our textured surface improves adhesion of the deposited material for at least two reasons. One reason is that vertical contours (contours perpendicular to the average surface plane) increase compressive forces within the deposited film in a direction normal to the surface, thereby resisting cracking of the film due to thermal expansion and contraction. A second reason is that a textured surface has a greater surface area for the material to bond to than a flat surface.

The surface area increases in proportion to the depth of the depressions or the height of the protrusions. While increasing the height dimension in order to increase the surface area by improves adhesion of deposited material, increasing the height beyond a certain value can become disadvantageous. First, an excessive height dimension can make the textured surface harder to clean. Secondly, if the textured surface is a thin, removable chamber lid or liner rather than a comparatively thick chamber wall, an excessive height dimension can reduce the strength and rigidity of the lid or liner, making it more susceptible to accidental damage.

The texturing of our invention can be applied to the surface of any component of the process chamber. (By "component" we mean any object in or on the chamber.) The texturing preferably should be applied to any large surface that is exposed to the process gases in the chamber interior and that is either above or near the wafer. The chamber surfaces for which it is most important to provide the texture of the invention typically are the lower surface of the chamber roof (i.e., the chamber lid or gas distribution plate) and the chamber side wall or lining. Since the chamber roof is directly above the wafer being processed, any particles that flake off of the roof probably will fall on the wafer, thereby causing a defect in the wafer. Since the chamber side wall or lining is very close to the perimeter of the wafer, there also is a high risk that particles flaking off the side wall or lining will fall on the wafer. It is much less important to provide textured surfaces on chamber components positioned below the wafer, since particles flaking off of such surfaces are unlikely to deposit on the wafer.

We tested different shapes and dimensions of depressions and protrusions in the exposed surfaces of the chamber roof and side wall lining. All shapes we tested greatly improved adhesion of deposited material compared with either smooth, untreated surfaces or surfaces roughened by bead blasting.

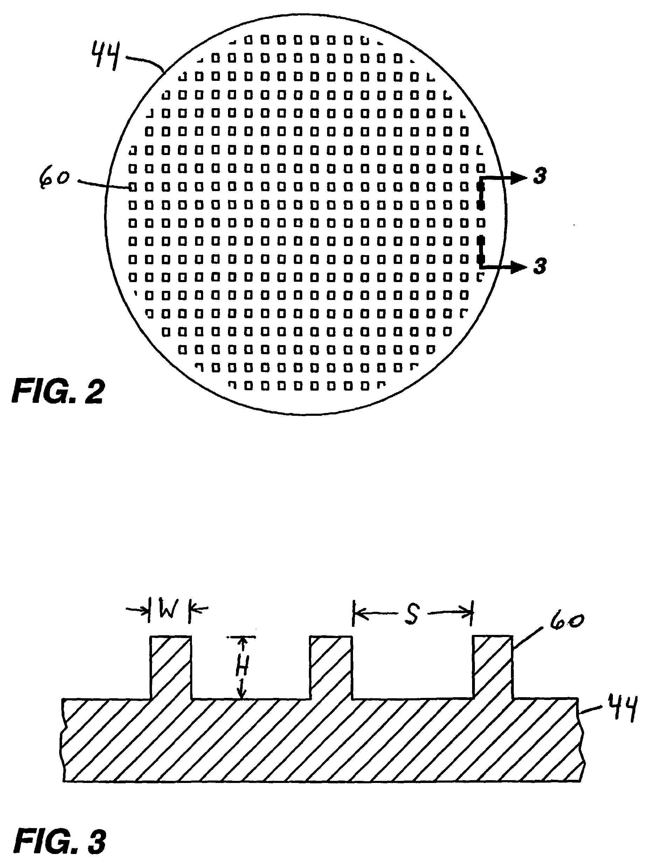

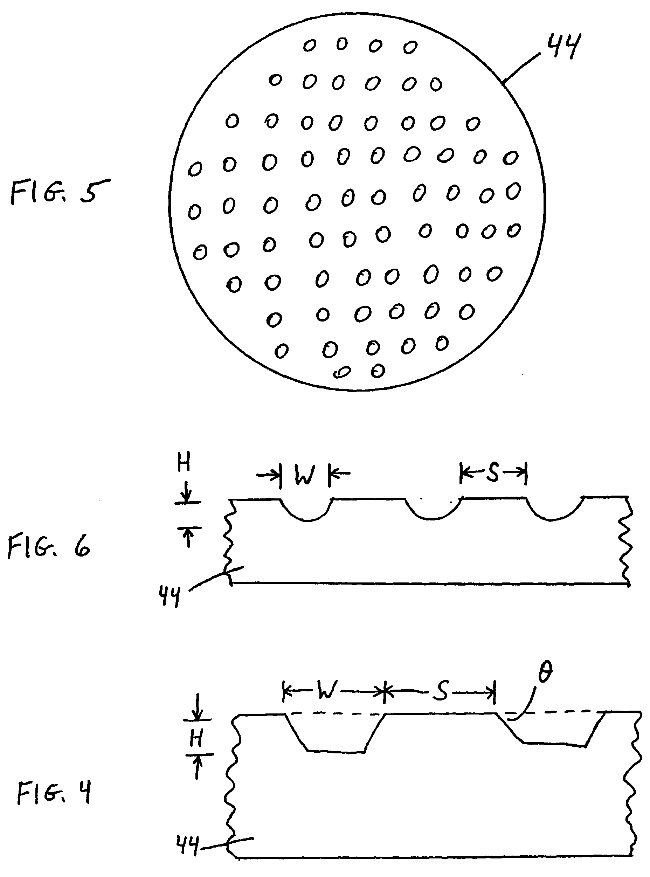

Figures 2 and 3 are top and sectional views, respectively, of the lower surface of a gas distribution plate 44 having a texture consisting of a 2-dimensional array of square protrusions 60. The protrusions have height H, width W, and spacing S between adjacent protrusions. Figure 4 shows a variation of this texture in which the topographical features are square depressions rather than protrusions, and in which the sides of the square depressions are formed at an oblique angle θ relative to the horizontal surface between the depressions, so that each depression is shaped as an inverted 4-sided pyramid with a flat bottom rather than a sharp apex. Figures 5 and 6 are top and sectional views of an alternative texture in which the depressions are rounded or hemispherical in shape.

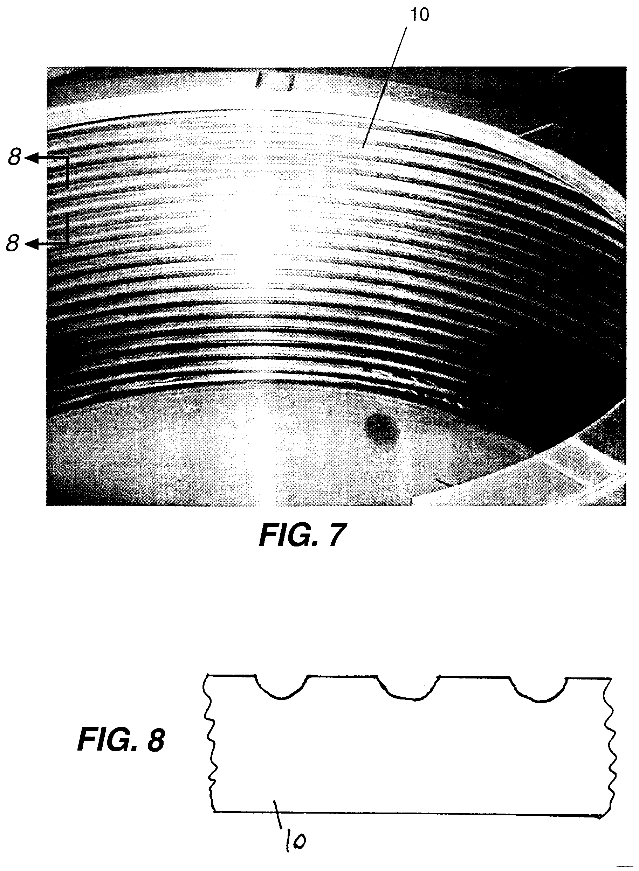

Figures 7 and 8 are perspective and sectional views, respectively, of a texture consisting of a series of circumferential grooves in a cylindrical side wall liner 10.

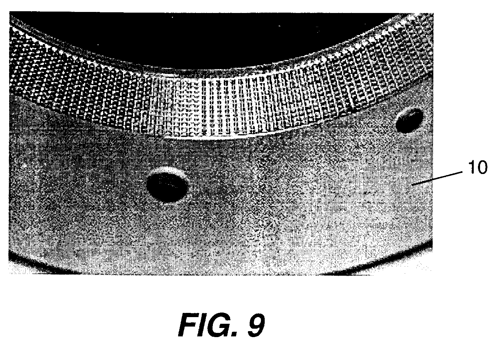

Figure 9 is a perspective view of a liner having both circumferential and longitudinal grooves.

While each topographical feature has been characterized as either a protrusion or a depression, it is equivalent to consider the area between the depressions to be protrusions on the surface. In other words, it is arbitrary whether the protrusions or the depressions are designated as the topographical features. Therefore, the spacing S between depressions or protrusions preferably should be the same order of magnitude as the width W. More preferably, the spacing S and width W should differ by a factor of 2 or less. Similarly, the height H preferably should be the same order of magnitude as the width W and spacing S, and more preferably should be within a factor of 2 of those other two dimensions.

In any of the embodiments, we expect the adhesion of the deposited film to the textured surface will maximized if there are no sharp corners in the textured surfaces of the chamber components, because sharp corners generally increase stress in the film. Consequently, the edges of the topographical features should have rounded corners, with as high a radius of curvature as practical. In the experimental examples described below, all of the topographical features were fabricated with rounded corners, with the radius of curvature ranging between 130 microns (0.13 mm) and 500 microns (0.5 mm). All of these curvature values performed equally well in our tests.

Casting and machining are two possible techniques for fabricating a desired texture of topographical features in the surface of a chamber component. Casting a component with the desired topographical features, as described in Example 1 below, is desirable because it can produce a smooth surface contour free of defects, but it is several times more expensive than machining. Machining the topographical features into the surface of a component, as described in Examples 2―5 below, potentially has the disadvantage of producing microscopic cracks in the surface which could create stress in the process byproduct material subsequently deposited on the component surface. However, in our testing the machined surfaces all exhibited good adhesion to the subsequently deposited polymer.

In each of the following tests, we had to terminate the test when polymer deposition on the electrostatic wafer chuck accumulated to the point at which the seal between the wafer and the chuck began to leak the helium gas used to transfer heat from the wafer to the chuck. Because this typically occurred before the polymer began flaking off of the textured surface of our invention, we were unable to compare the maximum possible polymer thickness that would adhere to the different surface textures we prototyped.

### Test Results ― Control

We tested the invention by using the plasma chamber of Figure 1 to perform a plasma process for etching films of silicon dioxide on silicon wafers, using a conventional fluorocarbon etchant gas mixture including C₄F₈ and CO. For the control, the process chamber had an aluminum nitride ceramic roof and an anodized aluminum side wall liner, both of which were smooth.

The etching process produces fluorocarbon reaction products which form polymer films on exposed inner surfaces of the chamber roof and side walls. We found that, with conventional smooth roof and side wall liner, the polymer deposited on these surfaces began flaking off after the polymer film reached a thickness of 0.6 to 0.65 mm. The thickness at which flaking occurred was independent of changes in process parameters.

We also tested a similar etching process in an experimental chamber similar to that shown in Figure 1, but which included a second RF power source inductively coupled to the plasma. Again, the polymer deposited on exposed surfaces of chamber components began flaking off after the polymer film reached a thickness of 0.6 to 0.65 mm.

### Example 1 ― Pyramid Depressions in Aluminum Nitride Roof

We fabricated a chamber roof (gas distribution plate) as a circular disk of aluminum nitride ceramic, 0.5 inch (13 mm) thick, in which we divided the lower circular surface of the roof (the surface exposed to the chamber interior) into four quadrants, with four different surface textures fabricated in the four quadrants. The first quadrant was smooth, and the second quadrant was bead blasted with silicon carbide particles.

The third and fourth quadrants both had the pyramid texture shown in Figure 4, with bead blasting subsequently applied to the fourth quadrant but not the third. The dimensions of the pyramid features were: angle θ = 45°, height H = 0.6 mm, width W = 1.5mm, spacing S = 0.6 mm. We calculate that the third quadrant had a surface area 30% greater than that of the first quadrant due to its pyramid texture.

**Table 1**

| Example 1 | | |
|---|---|---|
| Quadrant | Pyramid Texture | Bead Blasting |
| 1 | No | No |
| 2 | No | Yes |
| 3 | Yes | No |
| 4 | Yes | Yes |

Aluminum nitride ceramic is almost impossible to machine. Therefore, the aluminum nitride roof was fabricated by machining the pyramid pattern in a graphite mold, filling the mold with aluminum nitride particles, and then hot pressing the material at about 1600° C and sufficient pressure to sinter the aluminum nitride particles.

We expect that a pattern of square depressions or protrusions as shown in Figure 3 would be preferable to the pyramid-shaped depressions actually tested, because the square features have a greater surface area. As stated earlier, we expect that maximizing the surface area of the surface contour is advantageous in order to maximize the adhesion of the material deposited thereon. However, the pyramid depressions were easier to fabricate in the graphite mold.

We installed the roof in the chamber of Figure 1 and performed the same plasma etch process performed in the Control. We found that the third quadrant of the roof exhibited the best polymer adhesion. Compared to the smooth first quadrant, we were able to process 2.5 times more wafers before material deposited on the third quadrant began flaking. At this point, the polymer layer deposited on the third quadrant had a thickness of 1.2 mm, which is 85% thicker than the maximum polymer thickness that could be deposited on a conventional smooth or bead blasted surface without flaking.

Because bead blasting conventionally had been used to improve adhesion of deposited material, we were surprised to observe that bead blasting the pyramid textured surface was detrimental to adhesion. Specifically, when we halted the test after depositing 1.2 mm of polymer on the lid, we observed a small amount of flaking from the fourth quadrant, and no flaking whatsoever from the third quadrant We surmise that the bead blasting created sharp corners created in the surface of the roof that increased stress in the polymer film, thereby promoting cracks in the film.

### Example 2 ― Different Pyramid Dimensions in Aluminum Nitride Roof

A second aluminum nitride roof (gas distribution plate) was fabricated as described for Example 1. The four quadrants were textured with pyramids having different dimensions, as summarized in Table 1. In the first quadrant, the pyramid dimensions were identical to those of quadrant 3 of Example 1. In the other three quadrants, the height H of the pyramid depressions was increased to 1.1 mm. In quadrants 3 and 4, the angle θ of the pyramid walls relative to the horizontal surface was decreased to 30°. In quadrants 2 and 4, the width W and spacing S were increased to 2.5 mm and 1.0 mm, respectively. All four quadrants exhibited no flaking of the polymer deposits.

**Table 2**

| Example 2 | | | | |
|---|---|---|---|---|
| Quadrant | Angle θ | Height H | Width W | Spacing S |
| 1 | 45° | 0.6 mm | 1.5 mm | 0.6 mm |
| 2 | 45° | 1.1 mm | 2.5 mm | 1.0 mm |
| 3 | 30° | 1.1 mm | 1.5 mm | 0.6 mm |
| 4 | 30° | 1.1 mm | 2.5 mm | 1.0 mm |

### Example 3 ― Hemispherical Depressions in Aluminum Oxide Roof

We fabricated a roof of a 0.5 inch (13 mm) thick plate of aluminum oxide (alumina) ceramic. Alumina has a much lower thermal conductivity than aluminum nitride, but it has the advantage of being readily machinable. We created the pattern of depressions shown in Figures 5 and 6 by drilling in the alumina an array of approximately hemispherical holes, or holes having an arcuate cross section, having a hole diameter W of 4 mm and a spacing S between the perimeters of adjacent holes of 1 mm. We tested two prototypes in which the depth of the holes (the topographical feature height H) were 1 mm and 2 mm, respectively. Both prototypes exhibited no flaking of the polymer deposits.

### Example 4 ― Square Protrusions in Anodized Aluminum

Figures 2 and 3 show an aluminum roof (gas distribution plate) in which we machined an array of square protrusions. The aluminum was anodized after the machining. In one prototype the protrusions had 1 mm width W, 1.5 mm height H, and 3 mm spacing S. In a second prototype, the protrusions had 2 mm width W, 2 mm height H, and 5 mm spacing S. Both prototypes exhibited no flaking of the polymer deposits.

In the second prototype, we also tested an alternative implementation of the gas inlet holes in the gas distribution plate. Instead of a conventional array of gas inlet holes uniformly distributed over the surface of the plate, we installed in the plate only eleven quartz discs (not shown), where each quartz disc was 10 mm diameter and included eleven gas inlet holes 0.6 mm diameter.

### Example 5 ― Grooves in Anodized Aluminum

Figures 7 and 8 are perspective and sectional views, respectively, of a cylindrical side wall liner 10 composed of anodized aluminum in which we machined a series of circumferential grooves using a lathe. Each groove had 1 mm width and 1 mm depth, and adjacent grooves were spaced apart along the axis of the cylindrical liner by 3 mm. The aluminum was anodized after the machining.

Figure 9 is a perspective view of a similar cylindrical liner having both circumferential and longitudinal grooves of the same width, depth, and spacing dimensions stated in the preceding paragraph.

Both prototypes exhibited no flaking of the polymer deposits. However, the Figure 9 embodiment is expected to provide superior adhesion because its surface area is greater than that of the Figures 7―8 embodiment.

An advantage of the embodiments of Figures 7―9 is that machining grooves in aluminum typically is less expensive than the other fabrication methods described earlier.

### Effect of Temperature on Adhesion

Semiconductor fabrication process chambers typically include some provision for cooling the outer walls of the chamber in order to limit the temperature excursions of chamber components, because temperature fluctuations can make process performance inconsistent. Typically, cooling fluid is circulated through pipes surrounding the chamber walls.

Conventional semiconductor fabrication processes in which the chamber interior surfaces are cleaned after every wafer is processed typically operate with chamber wall temperatures well above 150° C. Conventional processes in which as many wafers as possible are processed between cleaning the chamber components typically operate with chamber wall temperatures well below 150° C ― specifically, 60°C in the silicon oxide etch process used in the preceding examples. Maintaining below 150°C the surfaces that are exposed to polymer deposition improves the adhesion of such polymers and minimizes flaking.

To maximize adhesion of deposits on surfaces of chamber components exposed to the chamber interior, the benefits of our novel texture and the benefits of cooling such surfaces below 150°C are synergistic. Therefore, we recommend performing such cooling, preferably at or below 60°C, in combination with the surface texture of our invention. In our preferred process chamber, we pump through pipes surrounding the chamber top and sides walls a cooling fluid maintained at 15°C.

### Other Types of Process Chambers

The invention also is beneficial in process chambers used for processes other than etching. For example, sputter deposition processes generally deposit a certain amount of sputtered material on exposed surfaces within the chamber. To facilitate removal of the deposits, sputter deposition chambers typically include removable shields protecting portions of the chamber walls. Applying the texturing of our invention to the removable shields, the chamber walls, and/or other exposed surfaces within the chamber would improve adhesion of the deposited material to the textured surfaces so as to allow the sputter deposition chamber to operate for much longer periods of time before cleaning or replacement of the textured surfaces.

## Claims

1. Apparatus for fabricating semiconductor devices, comprising:
a process chamber enclosing an interior region; and
a mechanical component having an exposed surface in the interior of the chamber;
wherein said surface includes a plurality of topographical features distributed across the surface;
wherein each topographical feature has a height in the range of 0.1 to 100 mm, inclusive, and a width in the range of 0.1 to 100 mm, inclusive; and
wherein adjacent topographical features are separated by a spacing in the range of 0.1 to 100 mm, inclusive.

2. Apparatus according to claim 1, wherein each topographical feature is a depression in said surface.

3. Apparatus according to claim 1, wherein each topographical feature is a protrusion in said surface.

4. Apparatus according to claim 1, wherein said surface includes an array of grooves whose height varies spatially in a wavy pattern alternating between peaks and troughs, so that each peak is a topographical feature of said surface.

5. Apparatus according to any one of the preceding claims wherein the mechanical component comprises a top wall of the chamber.

6. Apparatus according to any one of the preceding claims wherein the mechanical component comprises a removable lid of the chamber.

7. Apparatus according to any one of the preceding claims wherein the mechanical component comprises a side wall of the chamber.

8. Apparatus according to any one of the preceding claims wherein the mechanical component comprises a removable liner mounted between a side wall of the chamber and the interior.

9. Apparatus according to any one of the preceding claims wherein the height and width of each topographical feature are in the range of 0.5 to 8mm, inclusive, and wherein adjacent topographical features are separated by a spacing in the range of 0.5 to 8mm, inclusive.

10. Apparatus adapted for use in a semiconductor process chamber, comprising:
a body having a surface across which are distributed a plurality of topographical features;
wherein each topographical feature has a height in the range of 0.1 to 100 mm, inclusive, and a width in the range of 0.1 to 100 mm, inclusive; and
wherein adjacent topographical features are separated by a spacing in the range of 0.1 to 100 mm, inclusive.

11. Apparatus according to claim 10, wherein the height and width of each topographical feature are in the range of 0.5 to 8 mm, inclusive, and wherein adjacent topographical features are separated by a spacing in the range of 0.5 to 8 mm, inclusive.

12. A method of improving adhesion of material deposited on the surface of a mechanical component of a process chamber, comprising the steps of:
mounting said component so as to position said surface within the process chamber; and
forming on said surface a plurality of topographical features distributed across the surface;
wherein each topographical feature has a height in the range of 0.1 to 100 mm, inclusive, and a width in the range of 0.1 to 100 mm, inclusive; and
wherein adjacent topographical features are separated by a spacing in the range of 0.1 to 100 mm, inclusive.

13. A method according to claim 12, wherein the height and width of each topographical feature are in the range of 0.5 to 8 mm, inclusive, and wherein adjacent topographical features are separated by a spacing in the range of 0.5 to 8 mm, inclusive.

14. A method of fabricating semiconductor devices within a process chamber, comprising the steps of:
providing a process chamber having an interior region bounded by a wall, the wall having an inner surface facing the interior region;
forming on a portion of said inner surface a plurality of topographical features distributed across the surface, wherein
each topographical feature has a height in the range of 0.1 to 100 mm, inclusive, and a width in the range of 0.1 to 100 mm, inclusive, and
adjacent topographical features are separated by a spacing in the range of 0.1 to 100 mm, inclusive;
positioning a workpiece within the interior region; and
while the workpiece is positioned within the interior region, performing on the workpiece a step in a process for fabricating semiconductor devices on the workpiece.

15. A method according to claim 14, wherein the portion of the inner surface comprises a removable lid of the chamber.

16. A method according to any one of claims 14 to 15 wherein the portion of the inner surface comprises a removable liner mounted between an outer wall of the chamber and the interior.

17. A method according to any one of claims 14 to 16 wherein said step in the process for fabricating semiconductor devices comprises a process within the group consisting of:
(a) etching material on the wokpiece, or
(b) depositing material on the workpiece.
